Europäisches Patentamt

European Patent Office

Office européen des brevets

(11) Publication number: **0 044 048**
**A1**

(12) # EUROPEAN PATENT APPLICATION

(21) Application number: **81105364.4**

(22) Date of filing: **09.07.81**

(51) Int. Cl.³: **H 01 L 21/316**
**H 01 L 21/78, H 01 L 23/30**

(30) Priority: **10.07.80 US 168818**

(43) Date of publication of application:
**20.01.82 Bulletin 82/3**

(84) Designated Contracting States:
**BE CH DE FR GB IT LI NL SE**

(71) Applicant: **WESTINGHOUSE ELECTRIC CORPORATION**
**Westinghouse Building Gateway Center**
**Pittsburgh Pennsylvania 15222(US)**

(72) Inventor: **Ostop, John Anthony**
**Armburss Road**
**Youngwood Pennsylvania(US)**

(72) Inventor: **Johnson, Joseph Edgar**
**39 Churchil Road**
**Pittsburgh Pennsylvania(US)**

(74) Representative: **Fleuchaus, Leo, Dipl.-Ing. et al,**
**Fleuchaus & Wehser Melchiorstrasse 42**
**D-8000 München 71(DE)**

(54) Glass passivated high power semiconductor devices.

(57) The present invention is directed to a process for producing a glass passivated semiconductor device and to the device so produced. The process comprises forming at least one region having a second type of conductivity in a large area body of semiconductor material having a first type of conductivity, forming grooves (40, 42) through top and bottom surfaces (12, 14) of the large area body whereby a plurality of smaller area bodies are defined. The grooves (40, 42) are filled with a glass paste which is solidified in situ and the smaller bodies are cut from the larger body with a laser scribe. Each smaller body cut from the larger body includes the glass filled groove which defined it originally. Electrodes are then affixed to each of the smaller bodies thereby providing a semiconductor device.

FIG. 7

## GLASS PASSIVATED HIGH POWER
## SEMICONDUCTOR DEVICES

The present invention is directed generally to semiconductor devices and more specifically to semiconductor devices, and the process for preparing such devices, which utilizes a fused glass for passivation of p-n junctions; and to a method for preparing a plurality of devices from a single large area body of semiconductor material.

Prior art glass sealed thyristors, transistors and diodes have utilized a glass layer fused to an edge of a body of semiconductor material to form a seal protecting the p-n junctions formed at the interface of regions of opposite conductivity type. A typical example of a prior art glass seal is disclosed in patent application entitled, "Glass Encapsulated Diode", by Bulent E. Yoldas, Serial No. 897,323, filed April 18, 1978 and patent application entitled, "Glass Sealed Diode" by J. E. Johnson, Serial No. 891,090, filed March 28, 1978, both of which are assigned to the same assignee as this application.

These prior art devices utilized a body of semiconductor material having tapered edges. This results in a non-symmetrical device. Non-symmetry may increase stress which is induced by changes in temperature during duty cycles.

Another example of a prior art glass encapsulated device is set forth in a patent application entitled "Glass-Sealed Multichip Process" by J. E. Johnson, Serial No. 970,045, filed December 15, 1978. This prior art device employs preformed glass rings in its preparation. The use of such glass preforms requires extensive jigging apparatus to ensure the proper initial positioning of the glass preform and the maintaining of the positioning during melting and re-solidification of the glass.

The principal object of the invention is to provide a more reliable or inexpensive device than the prior art.

One aspect of the invention resides broadly in a process for making a semiconductor device comprising, forming, in a body of semiconductor unit having a PN junction and opposed top and bottom parallel surfaces, at least one groove in a given configuration through said top surface of said body and extending into said body a first given distance, forming an equal number of grooves in a given configuration through said bottom surface of said body and extending into said body a second given distance and being vertically aligned but not meeting with the top surface grooves, depositing a glass paste comprising a glass powder and a vehicle in said or each groove formed through said top surface, driving off said vehicle, depositing said glass paste in said grooves through said bottom surface and driving off said vehicle, hardening said glass in all of said grooves, cutting entirely through said body of semiconductor material at a point outside of the given configuration of said grooves, and metallizing predetermined portions of the portion cut from said body.

Another aspect of the invention resides broadly in a semiconductor device having a body with a PN junction and with opposed top and bottom surfaces with an edge portion extending therebetween, said body having a central portion and a peripheral portion, said central portion being isolated from said peripheral portion by a first groove extending from said top surface of said body into said body a first given distance and a second groove, vertically aligned with said first groove, extending from said bottom surface into said body a second given distance, and being vertically aligned with but not meeting with the top surface groove, a solidified glass disposed in said grooves and bonded to said body.

The present invention comprises a process for preparing a plurality of large area, high power, glass passivated semiconductor devices from a larger area body of semiconductor material having opposed top and bottom surfaces and containing at least two regions of opposite type conductivity with a p-n junction therebetween comprising; forming at least one groove in a circular configuration through said top surface of said body and extending into said body a first predetermined distance from said top surface where said groove terminates in a bottom surface, forming the same number of grooves in a circular configuration through said bottom surface of said body, said at least one groove through said bottom surface being vertically aligned with said at least one groove through said top surface, said at least one groove through said bottom surface extending into said body a second predetermined distance, said second predetermined distance being less than the distance from the bottom surface of the body to the bottom of said groove through said top surface, depositing a glass paste in said groove formed through said top surface, said glass paste comprising a glass powder and a vehicle, driving off said vehicle, depositing a glass paste in said groove through said bottom surface, said glass paste comprising a glass powder and a vehicle, driving off said vehicle and solidifying said glass in said grooves, cutting entirely through said body of semiconductor material around the outside of the circular configuration of said grooves, and metallizing predetermined portions of the portion cut from said body. The process provides a semiconductor device comprising a body of semiconductor material, said body having opposed top and bottom surfaces with an edge portion extending therebetween, said body having a central portion and a peripheral portion, said central portion being isolated from said peripheral portion by a first groove extending from said top surface of said body into said body a first predetermined distance and terminating at a bottom surface and a second groove, vertically aligned with said first groove, extending from said bottom surface into said body a second predetermined distance, said second predetermined distance being less than the distance from the bottom surface of the body to the bottom of said groove through said top surface, a solidified glass disposed in said grooves and bonded to said silicon, said central portion containing at least two regions of opposite type conductivity with a p-n junction between said regions, at least one of said p-n junction between said at least two regions terminating at one of said grooves.

For a better understanding of the present invention reference should be made to the following detailed discussion and drawings in which:

Figure 1 is a side view of a large area body of semiconductor material suitable for use in practicing the teachings of this invention;

Figure 2 is a schematic view of a typical thyristor made in accordance with the teachings of this invention;

Figure 3 is a side view of a dynamic gate thyristor made in accordance with the teachings of this invention;

Figure 4 is a top view of the large area body of Figure 1 being processed in accordance with the teachings of this invention;

Figures 5 and 6 are side views of a thyristor undergoing processing in accordance wih the teachings of the invention;

Figure 7 is a side view of a thyristor made in accordance with the teachings of this invention;

Figure 8 is a side view of a diode made in accordance with the teachings of this invention; and

Figure 9 is a side view of a transistor made in accordance with the teachings of this invention.

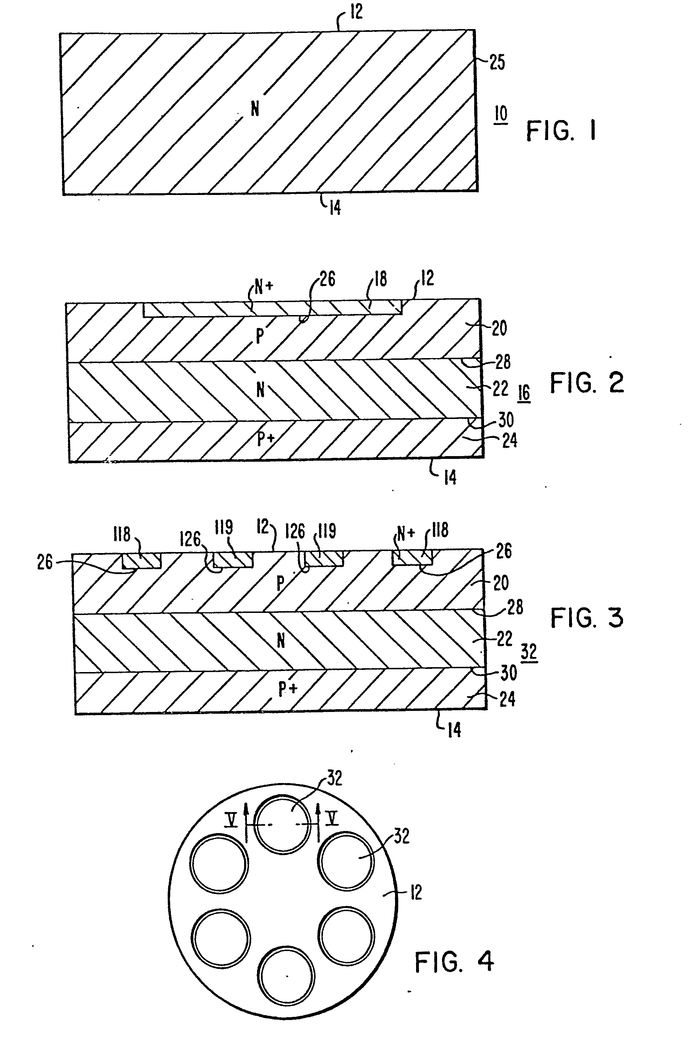

With reference to Figure 1, there is shown a large area body 10 of semiconductor material, preferably silicon suitable for use in accordance with the teachings of this invention for making a glass passivated, large area, high power semiconductor device and in particular a glass passivated, large area, high power thyristor.

Large area as used herein means a thyristor in which the body of semiconductor material has a diameter of at least 0.5 inch. Devices have been made on silicon chips having a diameter of from at least 0.625 to at least 0.91 inch. Devices are planned having a diameter of 1.3 inches.

High power as used herein means a thyristor capable of handling typical voltages of from at least 1000 volts and ranging to 1200 volts or more.

Typically the large area body 10, which comprises a suitable starting material, will have a diameter of 3.0 inches or more, a thickness of about 12 mils, will be of n-type conductivity and will have a resistivity of 40 ohm-cm.

The body 10 has a top surface 12 and a bottom surface 14. The top and bottom surfaces 12 and 14 respectively, are substantially flat and parallel. There is an edge portion 15 extending between surfaces 12 and 14.

Using conventional known diffusion or epitaxial-diffusion and photomasking techniques a plurality of thyristors such as thyristor 16, Figure 2, is formed in the body 10 of Figure 1.

The thyristor 16 of Figure 2 is shown schematically and is a typical high power thyristor suitable for processing in accordance with the teachings of the invention.

It should be understood that in practice the diffusion profile, which include junction depth and doping concentration are tailored according to the desired device characteristics. The diffusion profile discussed in relation to Figure 2 are such to produce a thyristor capable of handling 1000 to 1200 volts.

The thyristor 16 is comprised of a cathode emitter region 18, a cathode base region 20, an anode base region 22 and an anode emitter region 24.

There are p-n junctions between adjacent regions. A p-n junction 26 between regions 18 and 20, a p-n junction 28 between regions 20 and 22 and a p-n junction 30 between regions 22 and 24.

The cathode emitter region 18 has a thickness of from 15 to 20 microns, is of n-type conductivity, and doped to a concentration of approximately $10^{20}$ atoms per cc.

The cathode base region 20 has a thickness of from 65 to 75 microns, is of p-type conductivity and is doped to a surface concentration of approximately $5x10^{17}$ atoms per cc.

The anode base region 22 has a thickness of from 6.5 to 7.5 mils, is of n-type conductivity and has a resistivity of from 40 to 50 ohm-cm. Region 22 is the unconverted portion of the original body 10 of silicon.

The anode emitter region 24 has a thickness of from 65 to 75 microns, is of p-type conductivity and is doped to a surface concentration of at least $5x10^{19}$ atoms per cc. If the anode emitter region is doped to a surface concentration of less than $5 \times 10^{19}$ atoms/cc, the thyristor will have an unacceptably high forward voltage drop.

In the preferred embodiment, the teachings of this invention are used in the preparation of a plurality of large area, high voltage dynamic gate thyristor in the body 10.

A dynamic gate thyristor 32 is shown in Figure 3. All components which are the same or similar to the corresponding component in Figure 2 are identified by the same reference numeral used in Figure 2.

The differences between the two structures of Figures 2 and 3 is that (1) the thyristor of Figure 3 has a main cathode emitter region 118 and an auxiliary cathode region 119, both regions having a circular configuration, (2) there is p-n junction 26 between region 118 and region 20 and a p-n junction 126 between region 119 and region 20, and (3) portions 120 of cathode base region 20 extend to the top surface 12 of the thyristor 32, and of the body 10, between the regions 118 and regions 119.

The anode base region 22 and anode emitter region 24 are the same in the two devices.

In the preferred method of preparing the large area, high power thyristor of either Figs. 2 or 3, the regions 20 and 24 are formed in the body 10 of Fig. 1 by diffusion. Region 22 consists of the undiffused n-type portion of the body 10.

Surface 12 is then masked by known techniques and in the case of thyristor 16 of Fig. 2, region 18 is formed by diffusion in the desired portion of surface 12.

In the case of the thyristor 32 of Fig. 3, surface 12 is masked by known techniques and emitter segments 118 are formed in the desired portions of surface 12.

In the alternative, in the case of thyristor 32 of Fig. 3, the entire surface 12 is diffused forming a continuous n-type cathode emitter region extending entirely across the surface 12 of the body 10 and then using photomasking techniques; the portions 120 of region 20 are formed by diffusing through the cathode emitter region at predetermined locations.

With reference to Fig. 4, there is shown a top view of the body 10 with a plurality of thyristors 32 of Fig. 3 formed therein.

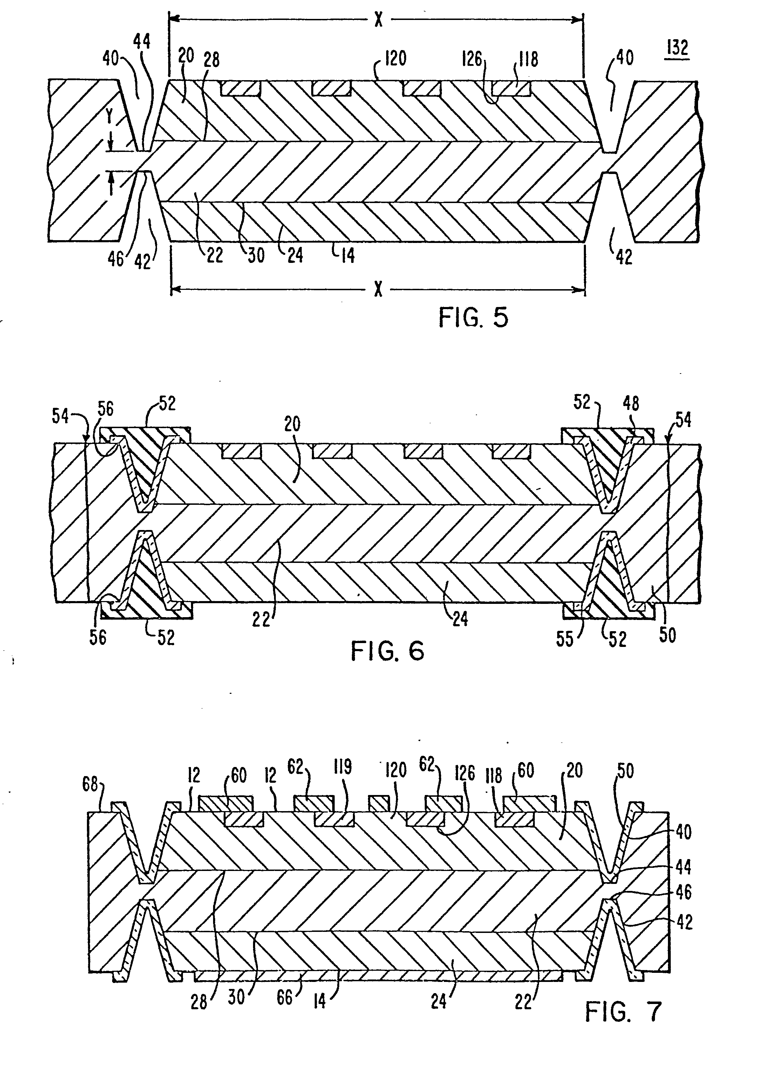

The top surface 12 of body 10 is covered with a chemical etchant resist, as for example that sold commercially under the trade name Waycoat SC and grooves 40 are etched through top surface 12 in a circular configuration into the body to a depth of at least 75 microns, and preferably deeper. The process is then repeated on and through the bottom surface 14 to form grooves 42. The grooves formed by etching through the top and bottom surfaces are aligned vertical. The depth of the grooves respectively should be greater than the depth of junctions 28 and 30. The distance Y, Fig. 5, between bottom surface 44 of groove 40 and bottom surface 46 of groove 42 should be about 30-40 microns. The width of the grooves should be about 25 mils at the surface, i.e. surfaces 12 and 14 and about 15 mils at the bottom surface of the groove. The grooves enclose within their circular configuration or circumference a quantity of semiconductor material.

A suitable etchant for forming the grooves is one consisting of, all parts by volume, 2 parts nitric acid, 1 part hydrofluoric acid and 1 part acetic acid.

With reference to Fig. 5 there is shown a cross-section 132 of a portion of the body 10, taken along the line V-V in Fig. 4, which includes particularly one of the plurality of thyristors 32.

Distance "X", the distance between grooves, is 0.500 inch, the regions of thyristor 32 included between the grooves comprises a large area high power thyristor as defined above.

After the etching of the grooves 40 and 42 the whole body 10 is cleaned alternately using solutions of hydrogen peroxide ($H_2O_2$), hydrochloric acid-water solution ($HCl-H_2O$), and hydrogen peroxide-ammonium hydroxide-water solution ($H_2O_2-NH_4OH-H_2O$) with water rinses between each successive cleaning step.

The hydrochloric acid water solution is comprised of, all parts by volume, 2 part hydrochloric acid, 5 parts water and 1 part hydrogen peroxide.

The hydrogen peroxide-ammonium hydroxide-water solution is comprised of, all parts by volume, 1 part hydrogen peroxide, 1 part ammonium hydroxide and 5 parts water.

The water used in the water rinse is 18 meg-ohm water.

A suitable glass powder, preferably having a nominal particle size of about 10 μm, is then mixed with a suitable vehicle to form a paste and with the use of a screen printer is printed into the grooves 40 and 42.

The glass employed in accordance with the teachings of this invention should first of all have an expansion coefficient near that of silicon, for example in the range of 4.0 to 6.0 x $10^{-6}$ centimeters per centimeter per degree C and should be substantially free of alkaline ions.

In addition:

(1) The glass must have structural stability, e.g., must not devitrify or go through phase separation during the fusion process.

(2) The glass must have good chemical resistance to the environment and humidity.

(3) The glass must wet and bond or adhere to the semiconductor material, normally silicon.

(4) The glass must not chemically attack the surfaces of the semiconductor material, normally silicon, in a detrimental way.

(5) The thermal characteristics of the glass must be such that stresses can be relieved at temperatures within the limitations of the device or the semiconductor material.

(6) The glass must have a fusion temperature below the degradation temperature of the device.

(7) The finished device must be resilient to thermal shock and thermal cycling and must have good mechanical strength.

In general, lead-aluminum borosilicate glasses have been found satisfactory. In particular glasses having a general chemical composition, by weight,

| Constituent | Percentage % |
|---|---|
| $SiO_2$ | 30-40 |
| $B_2O_3$ | 12-23 |
| PbO | 40-48 |
| $Al_2O_3$ | 2-6 |

have been found suitable.

Particularly suitable is a glass sold commercially by Innotech under the type number IP745 which has the specific composition, by weight,

| Constituent | Percentage % |
|---|---|
| $SiO_2$ | 36%±4% |
| $B_2O_3$ | 15%±3% |
| PbO | 45%±3% |
| $Al_2O_3$ | 3±1% |

Another particularly satisfactory glass is sold by Innotech under the type number IP740 which has nominal composition, by weight,

| Constituent | Percentage % |
|---|---|
| $SiO_2$ | 40% |
| $B_2O_3$ | 8.2% |
| $PbO_2$ | 49.3% |
| $Al_2O_3$ | 2.5% |

Lead borosilicate glasses are also satisfactory, such glasses will have a nominal composition, by weight,

| Constituent | Percentage % |
|---|---|
| $SiO_2$ | 30-40 |
| $B_2O_3$ | 12-23 |
| PbO | 40-48 |

Zinc aluminum silicate glasses are also satisfactory, such glasses will have a nominal composition, by weight,

| Constituent | Percentage % |
|---|---|
| ZnO | 40-50 |
| $Al_2O_3$ | 2-6 |
| $SiO_2$ | 50-60 |

Another particularly satisfactory glass is a zinc-borosilicate glass and in particular is one sold by JENA[ER] GLASWERK SCHOTT & GEN., under the type number G027-002 which has a nominal composition, by weight,

| Constituent | Percentage % |
|---|---|
| ZnO | 40-50 |
| $B_2O_3$ | 1-5 |
| $SiO_2$ | 50-60 |

and which can contain approximately, by weight 15% of the $SiO_2$ so particles of silica.

The vehicle in which the glass is mixed to form a paste may be a liquid or combination of liquids capable of supporting the particles of glass powder suspended therein to form a paste, while not having any deleterious effect upon the glass particles. In addition, the vehicle must be readily driven off from the paste by heating.

An example of a suitable vehicle is a mixture of ethyl cellulose and butyl carbitol. Another satisfactory vehicle is one sold commercially by Electro-Science Laboratory under the designation Vehicle No. 400.

The preferred vehicle for use with zinc-borosilicate glass is one comprising, 5 grams ethyl cellulose and 150 cc butyl carbitol.

The paste preferred for practicing the teachings of this invention consists of 40 grams of GO27-002 glass powder having a nominal particle size of 10 um and 35 cc of the ethyl cellulose-butyl carbitol vehicle.

The paste is printed into the grooves 40 using a screen printer with a 165 mesh screen. The printing is continued until the paste fills the groove 40.

The paste is allowed to set for approximately five to fifteen minutes, preferably about ten minutes, to allow it to settle or flow into all portions of the groove.

The structure is then heated for a period of from about eight to twelve minutes at a temperature in the range of from 100°C to 150°C to remove the excess vehicle from the paste. Normally this can be accomplished by heating with a heat lamp.

The structure is then inverted and the groove 42 are filled with glass in the same manner as described above.

It will be understood that while it is preferred to use the same glass in both the grooves 40 and 42, two different glasses may be used.

The structure is then placed in a quartz boat and heated in a furnace to a temperature in the range of 450°C to 550°C for a time period of from 20 minutes to 45 minutes; preferably, 500°C for 30 minutes. The purpose of this step is to remove or burn-off all of the vehicle from the glass in the grooves. Accordingly, time and temperature may be varied to accomplish this objective depending on the vehicle employed.

Following the drive-off step and without cooling down the structure is heated to a temperature in the range of from 650°C to 750°C, preferably 720°C, for from 45 minutes to 5 minutes, preferably about 10 minutes, to fully solidify or harden and bind the glass to the silicon.

If, as preferred, the drive-off and hardening and binding is carried out in one furnace, the temperature is increased from the preferred 500°C to the preferred 720°C over a period of time of about 10 to 20 minutes.

Following the heating, at preferably 720°C, for preferably 10 minutes, the furnace is cooled from the preferred 720°C to a temperature in the range of 525°C to 500°C in about 15 minutes. The furance is maintained in this range for approximately 10 minutes followed by a reduction to a temperature of about 480°C in about 15 minutes. The temperature of about 480°C is maintained for about 20 minutes followed by a reduction to about 410°C in about 15 minutes. This temperature is maintained for approximately 30 minutes followed by a reduction of the furnace temperature to room temperature at a rate of approximately 10°C per minute.

This cooling or annealing cycle relieves any harmful stresses in the glass.

With reference to Fig. 6, there is shown the cross-section 132 after glass 48 has been deposited in grooves 40 and glass 50 has been deposited in grooves 42.

Glass 48 and 50 is then coated with a layer 52 of a suitable photo resist using standard photolithographic techniques.

The photo resist used may be either a negative type resist or a positive resist. A negative resist is preferred.

Examples of suitable negative resists are those sold commercially as Hunts Waycoat SC and Eastman Kodak's resists designated as KTFR and KMER.

Examples of suitable positive resists are those sold commerically by Shipley under the designation 1350 and 1350H.

Following the application of the photo resist layer 52 to the deposited glass 48 and 50, the plurality of thyristors, represented by thyristor 32, are cut from the body 10 of silicon with a laser scribe.

The purpose of the resist is to protect the glass from particles of molten silicon generated by the laser cutting.

The laser scribe employs a Nd:Yag laser and such scribes are available commercially. A satisfactory laser scribe is one sold commercially by Quantronix Corp. with the designation Model 604.

The thyristors 32 are cut from the body 10 along a line 54 spaced about 20 to 40 mils from outside edge 56 of circular grooves 40 and 42. In practice, the cutting has normally been carried out at a distance of 62.5 mils from the inside edge 55 of the groove. The distance from the inside edge 55 or the outside edge 56 of the grooves to the scribe line is not critical and is governed only by the requirement of preserving the integrity of the glass filled grooves.

Following the laser scribing, electrodes, cathode, anode and gate are affixed to the various regions.

Preferably, the Electrodes are bimetallic consisting of a first layer about $1,500A^{\circ}$ thick of titanium (Ti) and a second layer about $20,000A^{\circ}$ thick of silver (Ag).

The metal electrode deposition may be accomplished by vapor deposition or sputtering.

Preferably, the metallization or affixing of the electrode is carried out using a shadow mask which defines the cathode emitter, gate and amplifying gate on one surface and the anode emitter on the opposed surface.

Following the affixing of the electrodes, the photo resist 52 is burned off the glass in an air ambient at 400°C.

With reference to Fig. 7, there is shown the completed large area, high power thyristor 32 made in accordance with the teachings of this invention.

The thyristor 32 is comprised of cathode emitter region 118, cathode base region 20, anode base region 22 and anode emitter region 24.

There is a p-n junction 126 between regions 118 and 20, a p-n junction 28 between regions 20 and 22 and a p-n junction 30 between regions 22 and 24.

Grooves 40 extend from top surface 12 into the thyristor to a depth greater than the depth of p-n junction 28 and grooves 42 extend into the thyristor beyond p-n junction 30.

Grooves 40 and 42 contain a quantity of hardened glass 48 and 50 respectively which passivates p-n junctions 28 and 30 where the junctions terminate at the grooves.

The glass in the grooves can have a thickness of about 0.5 mils if the lead-aluminum borosilicate glass is used and a thickness of about 2.0 mils if the zinc borosilicate glass is used. The difference in the thickness is due to the fact that the zinc borosilicate glass more closely matches the expansion coefficient of silicon. Obviously, if the coefficient of expansion of the lead-aluminum borosilicate glass or any other suitable glass is modified to approach the coefficient of expansion of silicon, as by the presence of silica flakes, the glass coating can be made thicker, i.e. approaching or equal to 2.0 mils.

There is a cathode emitter electrode 60, described above, making ohmic electrical contact to the cathode emitter region 118 and cathode base region 20. There is a floating gate electrode 62 described above, also in contact with the cathode emitter region 118 and the cathode base region 20 and a gate electrode 64 in ohmic electrical contact with the cathode base region 20. The cathode emitter electrode 60, the floating gate electrode 62 and the gate electrode 64 are disposed on top surface 12.

An anode emitter electrode 66 described above is in ohmic electrical contact with the anode emitter region 24 along bottom surface 14.

Portion 68 of silicon disposed along the outer periphery of grooves 40 and 42 and the glass 48 and 50 passivates the thyristor.

The thyristor of Fig. 7 may be encapsulated in resin or encased in any other known manner.

Thyristors made by the process of this invention and encapsulated in silicone resin such as that sold commercially as GE SR112 Silicone Resin have been found to be stable to at least 500 hours.

While the present invention has been described with particular reference to a thyristor, it is readily apparent that the invention is equally applicable to diodes and transistors.

As described above in detail, starting with a large diameter wafer or body of silicon, as for example a body of silicon having a diameter of about 3.0 inches, and having a first type of conductivity, a second region having an opposite type of conductivity is formed in or on the body by diffusion or epitaxial growth.

Grooves are then formed, as by chemical etching, in and through the top and bottom surface of the body, thereby in effect dividing the 3 inch body into a plurality of smaller bodies.

Using the procedure and materials set forth above relative to a thyristor, the grooves are filled with glass and after heat treating, the smaller bodies are cut from the 3 inch body with a laser scribe. With the affixing of electrodes, the diode is complete.

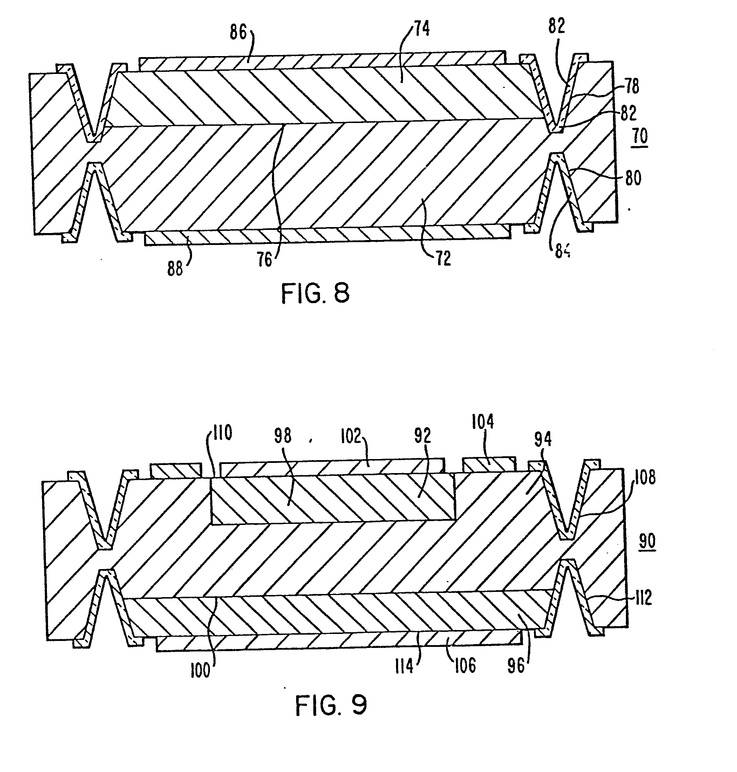

With reference to Fig. 8, there is shown such a diode 70.

The diode 70 has a region 72 of a first type conductivity and a region 74 of a second type conductivity with a p-n junction 76 therebetween.

Grooves 78 extend from the top surface of the diode into the diode to a depth greater than p-n junction 76.

Grooves 80 extend into the diode to a distance of about 30 to 40 microns from the bottom of grooves 78.

The grooves 78 and 80 contain a solidified glass 82 and 84 respectively which is bound to the side walls of the grooves.

A first electrode 86 is affixed in ohmic electrical contact with region 74 and a second electrode 88 is affixed in ohmic electrical contact with region 72.

With reference to Fig. 9, there is shown a planar transistor 90 made in accordance with the teachings of this invention.

The transistor 90 has an emitter region 92, a base region 94 and a collector region 96. There is a p-n junction 98 between regions 92 and 94 and a p-n junction 100 between regions 94 and 96.

There is also an emitter electrode 102, a base electrode 104 and a cathode electrode 106 affixed in ohmic electrical contact with regions 92, 94 and 96, respectively.

Groove 108 extends from top surface 110 into the transistor to a depth such that it is spaced about 30 to 40 microns from groove 112 which extends from bottom surface 114 into the transistor a distance greater than the distance between surface 114 and p-n junction 100.

The grooves 108 and 112 contain a solidified glass bound to the walls of the grooves.

The transistor 90 like the diode 70 may be encapsulated in a cured resin or in any other suitable method like the thyristor 32.

18

We claim as our invention:

1. A process for making a semiconductor device comprising, forming, in a body of semiconductor unit having a PN junction and opposed top and bottom parallel surfaces, at least one groove in a given configuration through said top surface of said body and extending into said body a first given distance,

characterized by forming an equal number of grooves in a given configuration through said bottom surface of said body and extending into said body a second given distance and being vertically aligned but not meeting with the top surface grooves,

depositing a glass paste comprising a glass powder and a vehicle in said or each groove formed through said top surface,

driving off said vehicle,

depositing said glass paste in said grooves through said bottom surface and driving off said vehicle,

hardening said glass in all of said grooves, cutting entirely through said body of semiconductor material at a point outside of the given configuration of said grooves, and metallizing predetermined portions of the portion cut from said body.

2. A process according to claim 1 in which the glass paste is comprised in part of a glass selected from the group consisting of lead aluminum borosilicate glass and zind borosilicate glass.

3. A process according to claim 1 or 2 in which the glass paste is comprised in part of a zinc borosilicate glass.

4. A process according to claim 1, 2 or 3 in which the glass paste is comprised in part of a vehicle consisting of ethyl cellulose and butyl carbitol.

5. A process according to claim 4 in which the glass paste is comprised of 40 grams of a zinc borosilicate glass and 35 cc of a vehicle comprised of ethyl cellulose and butyl carbitol.

6. A process according to any of the preceding claims in which the glass is deposited in the grooves by screen printing.

7. A process according to any of the preceding claims in which the glass is allowed to settle into the grooves for from 5 to 15 minutes before driving off the vehicle.

8. A process according to claim 7 in which the glass is allowed to settle into the grooves for 10 minutes before driving off the vehicle.

9. A process according to any of the preceding claims in which the vehicle is driven off by heating for a period of from 8 to 12 minutes at a temperature of from 100°C to 150°C.

10. A process according to any of the preceding claims in which the glass is hardened by heating for a period of from 20 minutes to 45 minutes at a temperature of from 450°c to 550°C, and then heated for a period of from 45 minutes to 5 minutes at a temperature of from 650°C to 750°C.

11. A process according to claim 10 in which the glass is hardened by heating for 30 minutes at 500°C and then for 10 minutes at 720°C.

12. A process according to any of the preceding claims in which a laser scribe is employed to cut through said body of semiconductor material.

13.  A process according to any of the preceding claims wherein said forming of said grooves is done in a circular configuration.

14.  A semiconductor device having a body with a PN junction and with opposed top and bottom surfaces with an edge portion extending therebetween, said body having a central portion and a peripheral portion, said central portion being isolated from said peripheral portion by a first groove extending from said top surface of said body into said body a first given distance and characterized by a second groove (42), vertically aligned with said first groove, extending from said bottom surface into said body a second given distance, and being vertically aligned with but not meeting with the top surface groove, a solidified glass (50) disposed in said grooves and bonded to said body.

15.  A device according to claim 14 wherein said PN junction extends to and terminates in one of said grooves.

FIG. 1

FIG. 2

FIG. 3

FIG. 4

0044048

FIG. 5

FIG. 6

FIG. 7

FIG. 8

FIG. 9

0044048

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| X | US - A - 3 628 107 (KENNEDY) <br> * claims 1, 2; column 4, lines 1 to 51; column 5, lines 18 to 46; fig. 3 * <br> -- | 1,14, 15 | H 01 L 21/316 <br> H 01 L 21/78 <br> H 01 L 23/30 |
| X | US - A - 3 608 186 (HUTSON) <br> * claims 1 to 4, 8; column 3, line 43 to column 5, line 38; fig. 2 to 5 * <br> -- | 1,14, 15 | |
| | GB - A - 2 003 662 (SEMIKRON) <br> * claim 11; page 2, lines 18 to 66; fig. 1 * <br> -- | 1,2,4 | **TECHNICAL FIELDS SEARCHED (Int. Cl.³)** <br><br> H 01 L 21/316 <br> H 01 L 21/56 <br> H 01 L 21/78 <br> H 01 L 23/28 |
| | US - A - 3 632 434 (HUTSON) <br> * claims 1, 3, 4; column 3, line 48 to column 4, line 20; column 4, lines 54 to 61 * <br> -- | 1,2 | |
| P | EP - A1 - 0 013 815 (WESTINGHOUSE) <br> * claims 1, 8; page 3, line 11 to page 4, line 8; page 7, lines 8 to 37; fig. 1 * | 1,2, 9-11 | |
| P,D | & US - A - 4 235 645 <br> -- | | **CATEGORY OF CITED DOCUMENTS** |
| | US - A - 3 755 720 (KERN) <br> * claim 1; column 2, line 49 to column 3, line 18 * <br> -- <br> ./.. | 2,3 | X: particularly relevant <br> A: technological background <br> O: non-written disclosure <br> P: intermediate document <br> T: theory or principle underlying the invention <br> E: conflicting application <br> D: document cited in the application <br> L: citation for other reasons |

&: member of the same patent family, corresponding document

X The present search report has been drawn up for all claims

| Place of search | Date of completion of the search | Examiner |
|---|---|---|
| Berlin | 07-10-1981 | GIBBS |

EPO Form 1503.1 06.78

BAD ORIGINAL

European Patent
Office

**EUROPEAN SEARCH REPORT**

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| A | SOLID STATE TECHNOLOGY, Vol. 19, No. 4, April 1970, Port Washington G.A. HARDWAY "Applications of Laser Systems to Microelectronics and Silicon Wafer Dicing" pages 63 to 67 * pages 64 to 65, section "Silicon Wafer Dicing" * | 12 | |
| | ---- | | TECHNICAL FIELDS SEARCHED (Int. Cl.³) |